(19) Europäisches Patentamt
European Patent Office
Office européen des brevets

(11) **EP 1 774 601 B1**

(12) **EUROPÄISCHE PATENTSCHRIFT**

(45) Veröffentlichungstag und Bekanntmachung des Hinweises auf die Patenterteilung:
**16.04.2008 Patentblatt 2008/16**

(21) Anmeldenummer: **05769757.5**

(22) Anmeldetag: **22.07.2005**

(51) Int Cl.:
*H01L 39/12* (2006.01)      *H01L 39/14* (2006.01)
*H01L 39/24* (2006.01)

(86) Internationale Anmeldenummer:
**PCT/DE2005/001307**

(87) Internationale Veröffentlichungsnummer:
**WO 2006/010364 (02.02.2006 Gazette 2006/05)**

(54) **SUPRALEITFÄHIGES LEITERELEMENT MIT VERSTÄRKUNG**

SUPERCONDUCTING CONDUCTOR ELEMENT WITH REINFORCEMENT

ELEMENT SUPRACONDUCTEUR A RENFORCEMENT

(84) Benannte Vertragsstaaten:
**AT BE BG CH CY CZ DE DK EE ES FI FR GB GR HU IE IS IT LI LT LU LV MC NL PL PT RO SE SI SK TR**

(30) Priorität: **23.07.2004 DE 102004035852**

(43) Veröffentlichungstag der Anmeldung:
**18.04.2007 Patentblatt 2007/16**

(73) Patentinhaber: **European Advanced Superconductors GmbH & Co. Kg**
**63450 Hanau (DE)**

(72) Erfinder:
• **ROTH, Gerhard**
**76287 Rheinstetten (DE)**
• **KRAUTH, Helmut**
**63456 Hanau (DE)**

(74) Vertreter: **Kohler Schmid Möbus**
**Patentanwälte**
**Ruppmannstrasse 27**
**70565 Stuttgart (DE)**

(56) Entgegenhaltungen:
**DE-A1- 2 331 962      DE-A1- 2 620 271**
**GB-A- 1 394 724      GB-A- 1 543 149**

• **WONG T ET AL: "TI AND TA ADDITIONS TO NB3SN BY THE POWDER IN TUBE PROCESS" IEEE TRANSACTIONS ON APPLIED SUPERCONDUCTIVITY, IEEE SERVICE CENTER, LOS ALAMITOS, CA, US, Bd. 11, Nr. 1, PART 3, März 2001 (2001-03), Seiten 3584-3587, XP001164368 ISSN: 1051-8223**
• **PATENT ABSTRACTS OF JAPAN Bd. 1997, Nr. 03, 31. März 1997 (1997-03-31) -& JP 08 287748 A (JAPAN ATOM ENERGY RES INST; HITACHI CABLE LTD), 1. November 1996 (1996-11-01)**
• **PATENT ABSTRACTS OF JAPAN Bd. 2003, Nr. 12, 5. Dezember 2003 (2003-12-05) -& JP 2005 032631 A (KOBE STEEL LTD; JAPAN SCIENCE & TECHNOLOGY CORP; TOKAI UNIV), 3. Februar 2005 (2005-02-03)**
• **PATENT ABSTRACTS OF JAPAN Bd. 2003, Nr. 12, 5. Dezember 2003 (2003-12-05) -& JP 2005 093235 A (KOBE STEEL LTD; JAPAN SCIENCE & TECHNOLOGY AGENCY; TOKAI UNIV), 7. April 2005 (2005-04-07)**

**Beschreibung**

Die Erfindung betrifft ein supraleitfähiges Leiterelement mit $Nb_3Sn$, insbesondere Multifilamentdraht, das mindestens ein supraleitfähiges Filament enthält, welches nach einem Ziehvorgang durch eine Festkörperdiffusionsreaktion aus einer Ausgangs-Filamentstruktur erhalten wird, die eine längliche hohle Röhre aus Niob oder eine Niob-Legierung, insbesondere NbTa oder NbTi, mit einer inneren Oberfläche und einer äußeren Oberfläche umfasst, wobei die Röhre in eine thermisch und elektrisch hochleitfähige Metallmatrix, insbesondere aus Kupfer eingebettet ist, und wobei die Röhre mit einem Material gefüllt ist, das Zinn enthält.

Supraleitfähige Leiterelemente mit $Nb_3Sn$ werden im Allgemeinen durch einen PIT (powder-in-tube) -Prozess hergestellt. Da die Legierung $Nb_3Sn$ extrem spröde ist, kann man sie keinem Ziehprozess unterziehen. Will man aus diesem Werkstoff mit seinen hervorragenden supraleitenden Eigenschaften trotzdem ein supraleitfähiges Leiterelement herstellen, wird zuerst eine Niob enthaltende Röhre mit Zinnpulver gefüllt und gezogen. Anschließend wird in einem Diffusionsprozess $Nb_3Sn$ gebildet. Dabei diffundiert das im Pulver enthaltene Zinn in die Niob-Röhre.

Durch PIT-Prozesse hergestellte supraleitfähige Leiterelemente werden oft zur Herstellung supraleitfähiger Spulen verwendet. Auf derartige Spulen wirken bei großen Stromdichten und großen Magnetfeldern jedoch starke Lorentzkräfte, die der Leiter ohne Beschädigung auffangen muss. Dies stellt insbesondere bei der Herstellung extrem dünner Filamente ein großes Problem dar. Um einen stabilen Betrieb der supraleitfähigen Leiterelemente zu gewährleisten, sollten die Filamente jedoch möglichst dünn ausgeführt sein. Hinsichtlich der Stabilität der Filamente ist daher zum einen die filigrane Ausführung der Filamente problematisch, zum anderen verändert sich die Querschnittsform der inneren Oberfläche der Niob-Röhre während des Ziehprozesses nicht in der selben Weise wie ihre äußeren Oberfläche. Durch den Ziehprozess kann es daher an verschiedenen Stellen zu unterschiedlich dicken Wandstärken der Niob-Röhre kommen. Dies wiederum hat zur Folge, dass das durch die Niob-Röhre hindurch diffundierende Zinn unterschiedlich schnell die Kupfermatrix erreicht und unter Umständen in die Kupfermatrix hinein diffundieren kann. Die dadurch resultierende Verringerung der Leitfähigkeit der Kupfermatrix bewirkt eine Verschlechterung der Kraftverträglichkeit des Filaments. Es ist daher üblich, die Menge an Zinn so gering zu halten, dass eine Diffusion des Zinns in die Kupfermatrix vermieden wird. Dies bedeutet jedoch, dass nicht das gesamte zur Verfügung stehende Niobmaterial zu $Nb_3Sn$ reagieren kann und somit entsprechend kleinere Mengen an supraleitfähigem Material produziert werden können beziehungsweise entsprechend mehr Ausgangsmaterial zur Verfügung gestellt werden muss, was wiederum den Durchmesser der Filamente vergrößert.

Aus "Filamentary A15 Superconductors" Masaki Suenaga; Alan F. Clark; PLENUM PRESS NEW YORK AND LONDON, 1980; S. 17-22 und dem Datenblatt "Lowtemperature superconductors" der Firma European Advanced Superconductors GmbH & Co. KG (http: //www.bruker.de/eas/pdf/eas_lts.pdf) sind supraleitfähige Leiterelemente bekannt, bei denen Niobfilamente in eine Bronzematrix eingebettet sind, wobei die Bronzematrix von einer hochleitfähigen Kupferschicht umgeben ist. Um eine Verunreinigung des Kupfers durch das Zinn zu vermeiden, ist zwischen der Bronzematrix und dem Kupfer eine Tantalfolie als Diffusionssperre vorgesehen.

Aus "Ti and Ta Additions to Nb3Sn by the Powder in Tube Process"; Terence Wong, Charles V. Renaud; IEEE Trans. Supercond. 11(2001), S. 3584-3587, geht ein supraleitfähiges Leitelement gemäß dem Oberbegriff des Anspruchs 1 hervor.

Aufgabe der vorliegenden Erfindung ist es, ein durch einen PIT-Prozess hergestelltes supraleitfähiges Leiterelement vorzuschlagen, welches eine verbesserte Stabilität und eine hohe Stromtragfähigkeit aufweist. Es ist des Weiteren eine Aufgabe der Erfindung ein Verfahren zur Herstellung eines solchen supraleitfähigen Leiterelements vorzuschlagen.

Diese Aufgabe wird erfindungsgemäß dadurch gelöst, dass einerseits zur mechanischen Verstärkung des Leiterelements andererseits als Diffusionssperre während der Festkörperdiffusionsreaktion die äußere Oberfläche der Röhre vor dem Ziehvorgang unmittelbar und vollständig mit einer Hülle aus einem metallischen Material umgeben ist, das bei Raumtemperatur einen thermischen Ausdehnungskoeffizienten $\alpha_{\text{Hülle}} < 17*10^{-6}K^{-1}$, vorzugsweise $\alpha_{\text{Hülle}} \leq 8*10^{-6}K^{-1}$, eine Streckgrenze $R_{p0,2} > 300$ MPa und eine Querschnittsreduktion $A > 10\%$ aufweist und wobei das metallische Material chemisch inert gegen diffundierendes Zinn bis zu einer Reaktionstemperatur T der Festkörperdiffusionsreaktions-Temperatur ist.

Um eine ausreichende Stabilität des erfindungsgemäßen Leiterelements zu gewährleisten, weist die die Röhre umgebende Hülle nach dem Ziehvorgang eine Dicke $d_H$ von 3 $\mu$m < $d_H$ < 15 $\mu$m.

Die Metallröhre dient als mechanische Stabilisierung des Filaments, welche die auf das Filament wirkenden Kräfte zumindest teilweise abfangen kann. Des Weiteren verhindert das metallische Material eine Diffusion des Zinns in die Kupfermatrix. Im Inneren der hohlen Röhre kann somit ein genügend großer Vorrat an zinnhaltigem Pulver vorgesehen sein, so dass das gesamte Niob der Hohlröhre zu $Nb_3Sn$ reagieren kann. Die Leitfähigkeit der hochleitfähigen Kupfermatrix wird auf diese Weise nicht negativ beeinflusst, wobei gleichzeitig eine maximale Ausbeute an supraleitfähigem $Nb_3Sn$ realisiert wird. Insgesamt ergibt sich ein äußerst stabiles supraleitfähiges Leiterelement mit einer hohen Stromtragfähigkeit.

Das in der Röhre befindliche Material ist ein Pulver, welches $NbSn_2$ enthält. In Form von Pulver kann ein großer Zinnvorrat eingefüllt werden, der durch die Diffusion in die Niob-Röhre und die Bildung von $Nb_3Sn$ eine hohe Stromtragfähigkeit des erfindungsgemäßen Leiterelements bewirkt.

Bei einer bevorzugten Ausführungsform weist die die Röhre umgebende Hülle Tantal oder eine Tantal-Legierung auf. Dies ist besonders vorteilhaft, da die Eigenschaften des Tantals die Erfordernisse des oben spezifizierten Metalls sehr gut erfüllen. So weist Tantal einen niedrigen thermischen Ausdehnungskoeffizienten und eine Streckgrenze auf, die groß genug ist, um den Ziehprozess innerhalb eines PIT-Prozesses standzuhalten.

Die vorteilhaften Eigenschaften des Tantals kommen besonders gut zur Geltung, wenn die die Röhre umgebende Hülle Tantal in einer atomaren Konzentration von $c_{Ta, Hülle} \geq 50\%$, vorzugsweise $c_{Ta, Hülle} \geq 90\%$ aufweist.

In einer weiteren Ausführungsform des erfindungsgemäßen Leiterelements weist die die Röhre umgebende Hülle zusätzlich Wolfram und/oder Molybdän und/oder Titan und/oder Vanadium und/oder Niob auf. Diese Materialien eigenen sich für die vorgesehene Anwendung besonders gut wegen ihrer hohen Schmelzpunkte.

Bei einer bevorzugten Ausführungsform enthält das in der Röhre befindliche Material Kupfer, wodurch die Diffusion des Zinns in der Niob-Röhre positiv beeinflusst wird.

Besonders vorteilhaft ist es, wenn die innere Oberfläche der Röhre mit Kupfer beschichtet oder mit einem Kupfer-Blech ausgekleidet ist. Beim Aufheizen legiert das Kupfer des Blechs mit dem Zinnpulver zu Bronze. Diese Bronzebildung wiederum begünstigt das Weiterdiffundieren des Zinns in die Niob-Röhre.

Für die Verwendung des erfindungsgemäßen Leiterelements für supraleitfähige Spulen weist die Röhre nach dem Ziehvorgang vorzugsweise einen maximalen äußeren Durchmesser $d_{max, R}$ von $3\,\mu m \leq d_{max, R} \leq 100\,\mu m$, vorzugsweise von $10\,\mu m \leq d_{max, R} \leq 50\,\mu m$ auf. Derartige Leiterelemente sind dünn genug, um einen stabilen Betrieb zu gewährleisten.

Typischerweise finden Leiterelemente Verwendung, bei denen die Röhre nach dem Ziehvorgang eine Wandstärke $W_{Röhre}$ von $5\,\mu m < W_{Röhre} < 20\,\mu m$ aufweist. Bei der Wahl der Wandstärke der Niob-Röhre ist der gewünschte Durchmesser des herzustellenden supraleitfähigen Filaments als auch die Eindringtiefe des Zinns ausschlaggebend, da aufgrund der begrenzten Eindringtiefe des Zinns bei sehr dicke Niob-Röhren im Außenbereich der Röhre kein $Nb_3Sn$ mehr gebildet wird, und somit Niob-Material unreagiert zurück bleibt.

Das erfindungsgemäße Leiterelement kann durch ein Verfahren hergestellt werden, bei dem einerseits zur mechanischen Verstärkung des Leiterelements, andererseits als Diffusionssperre während der Festkörperdiffusionsreaktion die äußere Oberfläche der Röhre vor dem Ziehvorgang unmittelbar und vollständig mit einer Hülle aus einem metallischen Material umgeben wird, wobei die Hülle bei Raumtemperatur einen thermischen Ausdehnungskoeffizienten $\alpha_{Blech} < 17*10^{-6}K^{-1}$, vorzugsweise $\alpha_{Blech} < 8*10^{-6}K^{-1}$, eine Streckgrenze $R_{p0,2} > 300$ MPa und eine Querschnittsreduktion $A > 20\%$ aufweist und wobei das metallische Material so gewählt wird, dass es chemisch inert gegen diffundierendes Zinn bis zu einer Reaktionstemperatur T der Festkörperdiffusionsreaktionstemperatur ist.

Bei einer vorteilhaften Variante des Verfahrens wird die Festkörperdiffusionsreaktion bei einer Reaktionstemperatur T von $400°C \leq T \leq 800°C$, vorzugsweise $550°C \leq T \leq 700°C$ ausgeführt wird, wobei die Festkörperdiffusionsreaktion insbesondere mittels HIP (high temperature isostatic pressing) durchgeführt wird. Auf diese Weise wird eine schnelle, effektive Reaktion des Niobs mit dem Zinn erreicht.

Die Festkörperdiffusionsreaktion wird bei einer vorteilhaften Variante des erfindungsgemäßen Verfahrens in einer sauerstofffreien Atmosphäre mit einem Sauerstoff-Partialdruck von $p_{O2} \leq 10^{-3}$ mbar, insbesondere im Vakuum oder in einer Inertgas-Atmosphäre, die vorzugsweise Argon und/oder Stickstoff enthält, durchgeführt. Somit können unerwünschte Oxidationsprozesse vermieden werden.

Besonders vorteilhaft ist es, wenn die Reaktionsbedingungen der Festkörperdiffusionsreaktion, insbesondere die Reaktionstemperatur T, die Reaktionszeit t, und/oder die Heizrate R so gewählt werden, dass sämtliches in der Röhre der Ausgangs-Filamentstruktur befindliche Niob zu $Nb_3Sn$ reagiert. Auf diese Weise wird eine maximale Menge an supraleitfähigem Material erzeugt und somit eine hohe Leitfähigkeit des erfindungsgemäßen Leiterelements realisiert.

Bei einer weiteren Variante des erfindungsgemäßen Verfahrens werden die Reaktionsbedingungen der Festkörperdiffusionsreaktion, insbesondere die Reaktionstemperatur T, die Reaktionszeit t, und/oder die Heizraten R, so gewählt, dass die atomare Konzentration des Zinns in der $Nb_3Sn$-Phase des supraleitfähigen Filaments mindestens 23%, vorzugsweise mindestens 24% beträgt. Diese hohe Zinnkonzentration ist wünschenswert, um die supraleitende Eigenschaften des Nb3Sn, insbesondere die kritische Temperatur und die kritische Feldstärke, zu verbessern.

Weitere Vorteile der Erfindung ergeben sich aus der Beschreibung und den Zeichnungen. Ebenso können die vorstehend genannten und die weiter aufgeführten Merkmale je für sich oder zu mehreren in beliebigen Kombinationen Verwendung finden. Die gezeigten und beschriebenen Ausführungsformen sind nicht als abschließende Aufzählung zu verstehen, sondern haben vielmehr beispielhaften Charakter für die Schilderung der Erfindung.

Es zeigen:

Fig. 1 eine schematische Darstellung eines supraleitfähigen Leiterelements mit einer Vielzahl an Filamenten;

Fig. 2     eine schematische Darstellung eines Ausschnitts eines supraleitfähigen Leiterelements gemäß Fig. 1 nach einer Festkörperdiffusionsreaktion;

Fig. 3     eine schematische Darstellung einer Ausgangs-Filamentstruktur eines supraleitfähigen Leiterelements gemäß der vorliegenden Erfindung; und

Fig. 4     eine schematische Darstellung eines Ausschnitts eines supraleitfähigen Leiterelements gemäß der vorliegenden Erfindung nach einer Festkörperdiffusionsreaktion.

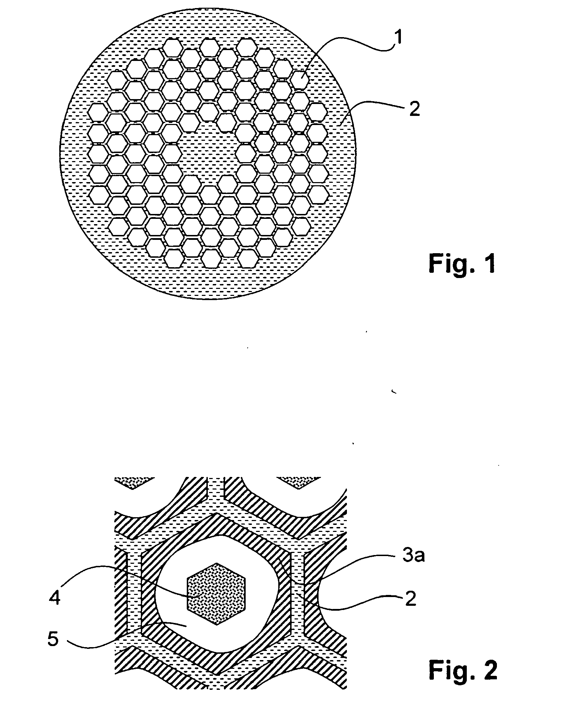

**Fig. 1** zeigt ein supraleitfähiges Leiterelement mit einer Vielzahl an Filamenten **1,** die in einer Metallmatrix **2** (beispielsweise aus Kupfer) eingebettet sind. Durch einen Ziehvorgang haben sich sechseckige Filamentquerschnitte ausgebildet. Die Filamente 1 umfassen eine längliche Röhre **3,** die Niob enthält und sind mit einem Pulver **4** gefüllt, das Komponenten aufweist, die in die Röhre 3 hinein diffundieren können und dort ein supraleitfähiges Material (vorzugsweise eine $Nb_3Sn$-Schicht **5**) erzeugen. Als Pulvermaterial eignet sich besonders gut Zinn oder eine Zinnlegierung. Die Diffusion des Zinns in die Niobröhre 3 wird besonders begünstigt, wenn das Zinn in Form von Bronze vorliegt. Da jedoch Bronze nur zu 15 % mit Zinn beladbar ist, wird im Allgemeinen kein reines Bronzepulver, sondern mit Zinn versetzte Bronze verwendet. Eine weitere Möglichkeit, den Diffusionsprozess zu unterstützen besteht darin, die innere Oberfläche 8 der Röhre 3 mit Kupfer zu beschichten oder mit einem Kupferblech auszukleiden (nicht gezeigt). Durch das Aufheizen während der Festkörperdiffusionsreaktion legiert ein Teil des Zinnpulvers 4 mit der Kupferbeschichtung zu Bronze, so dass ein Weiterdiffundieren des Zinns aus dem Pulver 4 in die Niobröhre 3 begünstigt wird.

**Fig. 2** zeigt, dass bei Leiterelementen aus dem Stand der Technik nicht die gesamte Röhre 3 zu einer $Nb_3Sn$-Phase **5** reagiert, sondern eine unreagierte Schicht **3a** aus dem Röhrenmaterial um die supraleitfähige Nb3Sn-Phase **5** verbleibt. Würde die Menge und die Konzentration des Zinns im Pulver 4 beziehungsweise die die Wandstärke der Röhre 3 so gewählt werden, dass sämtliches in der Röhre 3 enthaltene Nb zu $Nb_3Sn$ reagiert, so bestünde die Gefahr, dass Zinn aus dem Pulver 4 in die Metallmatrix 2 diffundiert und somit die Leitfähigkeit der Metallmatrix 2 und die Stabilität des Leiterelements negativ beeinflusst.

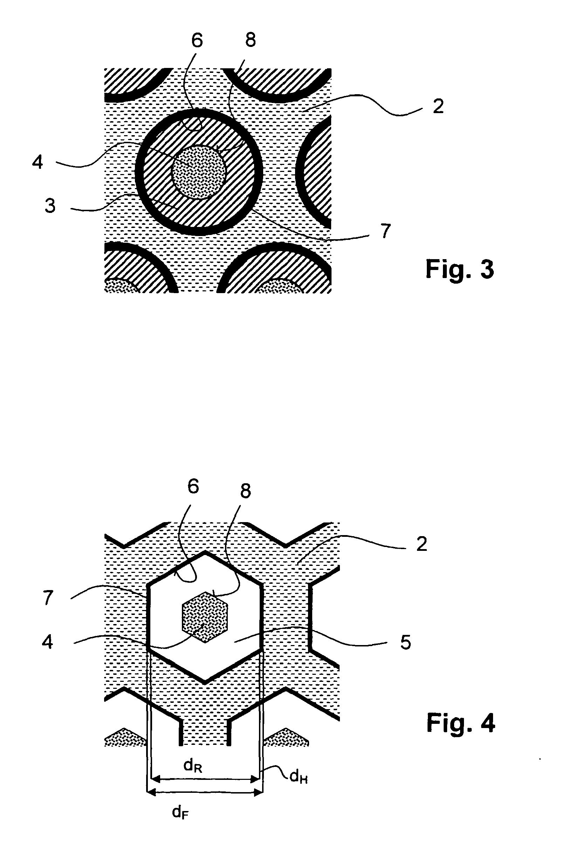

Um die Stabilität der Filamente 1 eines supraleitfähigen Leiterelements zu erhöhen, weist das erfindungsgemäße Leiterelement um die äußere Oberfläche **6** der Röhre 3 eine stabilisierende metallische Hülle **7** auf (**Fig. 3**). Das metallische Material der Hülle 7 muss zum einen einen genügend kleinen Ausdehungskoeffizienten und eine genügend große Streckgrenze und Querschnittsreduktion aufweisen, damit die Hülle 7 die Streck- und Hitzebehandlung der Ausgangsfilamentstruktur unbeschadet übersteht, zum anderen muss das metallische Material der Hülle 7 nach der Festkörperdiffusionsreaktion eine ausreichende Festigkeit aufweisen, um die supraleitfähigen Filamente 1 zu stabilisieren. Als Material für eine solche stabilisierende Hülle 7 kommt beispielsweise Tantal oder Kupfertitan in Frage. Während Kupfertitan lediglich durch seine mechanischen Eigenschaften eine stabilisierende Wirkung auf die Filamente 1 ausübt, weist eine Hülle 7 aus Tantal darüber hinaus den Vorteil auf, dass sie auch als Diffusionssperre dienen kann, um eine Diffusion des Zinns aus dem Pulver 4 in die Metallmatrix 2 zu verhindern. Selbstverständlich ist auch eine Kombination verschiedener Materialien als Hüllenmaterial denkbar.

Fig. 4 zeigt ein Filament 1 eines erfindungsgemäßen Leiterelements, bei dem sämtliches in der Röhre 3 enthaltene Niob zu $Nb_3Sn$ reagiert ist. Durch die erfindungsgemäße Hülle 7, welche chemisch inert gegen diffundierendes Zinn ist, erfolgt kein Übergang von Zinn in die Metallmatrix. Auf diese Weise kann das Nb-Material auf effektive Weise zu einer supraleitfähigen $Nb_3S$-Phase 5 reagieren. Die erfindungsgemäße Hülle 7 trägt somit direkt, durch ihre verstärkenden mechanischen Eigenschaften, sowie indirekt, indem die Hülle 7 eine Diffusion von Zinn in die Metallmatrix 2 und somit eine Reduktion der Leitfähigkeit des Leiterelements und der daraus resultierenden verringerten Kraftbeständigkeit verhindert, zur Stabilisierung der Filamente 1 bei. Durch die erfindungsgemäße Stabilisierung wird bei dem erfindungsgemäßen Leiterelement die Verwendung dünnerer Röhren 3 und die Herstellung einer kontrollierten Menge an $Nb_3Sn$ ermöglicht, nämlich indem die Wandstärke $W_R$ der Röhre 3 so gewählt wird, dass das gesamte in der Röhre 3 befindliche Niob mit dem Zinn aus dem Pulver 4 zu einer supraleitfähigen $Nb_3Sn$-Phase 5 reagieren kann (**Fig. 4**). Der Durchmesser $d_F$ des Filaments 1 ist gegeben durch den Durchmesser $d_R$ der Röhre 3 und der doppelten Dicke $d_H$ der Hülle 7.

$$d_F = d_R + 2d_H$$

Durch den reduzierten Durchmesser $d_R$ der Röhre 3 und der zusätzlich vorgesehenen verstärkenden Hülle 7 ergibt sich im Vergleich zu bekannten Filamentstrukturen bei vergleichbarem Gesamtdruchmesser $d_F$ der Filamente 1 ein widerstandsfähigeres Leiterelement, das beispielsweise für MR-Anwendungen zur Erzeugung höherer Magnetfelder eingesetzt werden kann. Insgesamt ergibt sich bei einer effektiven Nutzung des Hüllenmaterials ein mechanisch stark belastbares supraleitfähiges Leiterelement mit kleinem Durchmesser.

**Bezugszeichenliste**

| | |
|---|---|
| 1 | Filament |
| 2 | Metallmatrix |
| 3 | Röhre |
| 3a | unreagierte Schicht |
| 4 | Pulver |
| 5 | $Nb_3Sn$-Phase |
| 6 | äußere Oberfläche der Röhre |
| 7 | Hülle |
| 8 | innere Oberfläche der Röhre |

**Patentansprüche**

1. Supraleitfähiges Leiterelement mit $Nb_3Sn$, insbesondere Multifilamentdraht, das mindestens ein supraleitfähiges Filament (1) enthält, welches nach einem Ziehvorgang durch eine Festkörperdiffusionsreaktion aus einer Ausgangs-Filamentstruktur erhalten wird, die eine längliche hohle Röhre (3) aus Niob (Nb) oder einer Nb-Legierung, insbesondere NbTa oder NbTi, mit einer inneren Oberfläche (8) und einer äußeren Oberfläche (6) umfasst, wobei die Röhre (3) in eine thermisch und elektrisch hochleitfähige Metallmatrix (2), insbesondere aus Kupfer (Cu), eingebettet ist, und wobei die Röhre (3) mit einem pulverförmigen Material (4) gefüllt ist, das Zinn (Sn) enthält, wobei als Diffusionssperre während der Festkörperdiffusionsreaktion die äußere Oberfläche (9) der Röhre (3) vor dem Ziehvorgang unmittelbar und vollständig mit einer Hülle (7) aus einem metallischen Material umgeben ist, das bei Raumtemperatur einen thermischen Ausdehnungskoeffizienten $\alpha_{Hülle} < 17 \cdot 10^{-6} \ K^{-1}$, vorzugsweise $\alpha_{Hülle} \leq 8 \cdot 10^{-6} \ K^{-1}$, eine Streckgrenze $R_{p0,2} > 300$ MPa und eine Querschnittsreduktion A > 20%, aufweist und wobei das metallische Material chemisch inert gegen diffundierendes Zinn (Sn) bis zu einer Reaktionstemperatur T der Festkörperdiffussionsreaktions-Temperatur ist, und dass das in der Röhre (3) befindliche Pulver (4) $NbSn_2$ enthält, **dadurch gekennzeichnet, dass** zur mechanischen Verstärkung des Leiterelements die die Röhre (3) umgebende Hülle (7) nach dem Ziehvorgang eine Dicke d Hülle von $3 \ \mu m < d_{Hülle} < 15 \ \mu m$ aufweist.

2. Leiterelement nach Anspruch 1, **dadurch gekennzeichnet, dass** die die Röhre (3) umgebende Hülle (7) Tantal (Ta) oder eine Tantal-Legierung aufweist.

3. Leiterelement nach Anspruch 2, **dadurch gekennzeichnet, dass** die die Röhre (3) umgebende Hülle (7) Tantal (Ta) in einer atomaren Konzentration von $c_{Ta, Hülle} \geq 50\%$, vorzugsweise $c_{Ta, Hülle} \geq 90\%$, aufweist.

4. Leiterelement nach einem der Ansprüche 2 oder 3, **dadurch gekennzeichnet, dass** die die Röhre (3) umgebende Hülle (7) Wolfram (W) und/oder Molybdän (Mb) und/oder Titan (Ti) und/oder Vanadium (V) und/oder Niob (Nb) aufweist.

5. Leiterelement nach einem der vorhergehenden Ansprüche, **dadurch gekennzeichnet, dass** das in der Röhre (3) befindliche Material (4) Kupfer (Cu) enthält.

6. Leiterelement nach einem der vorhergehenden Ansprüche, **dadurch gekennzeichnet, dass** die innere Oberfläche (8) der Röhre (3) mit Kupfer (Cu) beschichtet oder mit einem Kupfer-Blech ausgekleidet ist.

7. Leiterelement nach einem der vorhergehenden Ansprüche, **dadurch gekennzeichnet, dass** die Röhre (3) nach dem Ziehvorgang einen maximalen äußeren Durchmesser $d_{max, R}$ von $3 \ \mu m \leq d_{max, R} \leq 100 \ \mu m$, vorzugsweise von $10 \ \mu m \leq d_{max, R} \leq 50 \ \mu m$, aufweist.

8. Leiterelement nach einem der vorhergehenden Ansprüche, **dadurch gekennzeichnet, dass** die Röhre (3) nach dem Ziehvorgang eine Wandstärke $w_{Röhre}$ von $1 \ \mu m < w_{Röhre} < 20 \ \mu m$, aufweist

9. Verfahren zur Herstellung eines supraleitfähigen Leiterelements nach einem der vorhergehenden Ansprüche, wobei als Diffusionssperre während der Festkörperdiffusionsreaktion die äußere Oberfläche (6) der Röhre (3) vor dem Ziehvorgang unmittelbar und vollständig mit einer Hülle (7) aus einem metallischen Material umgeben wird, wobei die Hülle (7) bei Raumtemperatur einen thermischen Ausdehnungskoeffizienten $\alpha_{Blech} < 17 \cdot 10^{-6} \ K^{-1}$, vorzugsweise $\alpha_{Blech} \leq 8 \cdot 10^{-6} \ K^{-1}$, eine Streckgrenze $R_{p0,2} > 300$ MPa und eine Querschnittsreduktion A > 20%, aufweist und wobei das metallische Material so gewählt wird, dass es chemisch inert gegen diffundierendes Zinn (Sn) bis zu einer Reaktionstemperatur T der Festkörperdiffussionsreaktions-Temperatur ist, **dadurch gekennzeichnet, dass** zur mechanischen Verstärkung des Leiterelements die Dicke des Materials der Hülle (7) so gewählt wird, dass die Hülle nach dem Ziehvorgang eine Dicke d Hülle von $3 \ \mu m < d_{Hülle} < 15 \ \mu m$ aufweist.

10. Verfahren nach Anspruch 9 zur Herstellung eines supraleitfähigen Leiterelements nach einem der Ansprüche 1 bis 8, **dadurch gekennzeichnet, dass** die Festkörperdiffusionsreaktion bei einer Reaktionstemperatur T von $400°C \leq T \leq 800°C$, vorzugsweise $550°C \leq T \leq 700°C$ ausgeführt wird, wobei insbesondere vor der Festkörperdiffusionsreaktion ein HIP-Prozess (high temperature isostatic pressing) durchgeführt wird.

11. Verfahren nach einem der Ansprüche 9 oder 10 zur Herstellung eines supraleitfähigen Leiterelements nach einem der Ansprüche 1 bis 8, **dadurch gekennzeichnet, dass** die Festkörperdiffusionsreaktion in einer Sauerstoff ($O_2$) freien Atmosphäre mit einem Sauerstoff-Partialdruck von $p_{O2} \leq 10^{-3}$ mbar, insbesondere im Vakuum oder in einer Inertgas-Atmosphäre, die vorzugsweise Argon (Ar) und/oder Helium (He) und/oder Stickstoff ($N_2$) enthält, durchgeführt wird.

12. Verfahren nach einem der Ansprüche 9 bis 11 zur Herstellung eines supraleitfähigen Leiterelements nach einem der Ansprüche 1 bis 8, **dadurch gekennzeichnet, dass** die Reaktionsbedingungen der Festkörperdiffusionsreaktion, insbesondere die Reaktionstemperatur T, die Reaktionszeit t, und/oder die Heizraten R, so gewählt werden, dass sämtliches in der Röhre (3) der Ausgangs-Filamentstruktur befindliche Niob (Nb) zu $Nb_3Sn$ reagiert.

**Claims**

1. Superconductive conductor element comprising $Nb_3Sn$, in particular a multifilament wire, which contains at least one superconductive filament (1) which is obtained after drawing through a solid diffusion reaction from an initial filament structure that comprises an elongated hollow tube (3) of niobium (Nb) or an Nb alloy, in particular NbTa or NbTi, with an inner surface (8) and an outer surface (6), wherein the tube (3) is embedded into a thermally and electrically highly conductive metal matrix (2), in particular of copper (Cu), and wherein the tube (3) is filled with a powdery material (4) containing tin (Sn), wherein, prior to drawing and as a diffusion barrier during the solid diffusion reaction, the outer surface (9) of the tube (3) is directly and completely surrounded by a sleeve (7) of metallic material which has a thermal expansion coefficient at room temperature of $\alpha_{sleeve}$ $17*10^{-6}$ $K^{-1}$, preferably $\alpha_{sleeve} \leq 8*10^{-6}$ $K^{-1}$, an elastic limit $R_{p0.2} > 300$ MPa and a cross-sectional reduction A > 20%, and wherein the metallic material is chemically inert to diffusing tin (Sn) up to a reaction temperature T of the solid diffusion reaction temperature, and that the powder (4) contained in the tube (3) contains $NbSn_2$,
**characterized in that**
the sleeve (7) that surrounds the tube (3) has a thickness $d_{sleeve}$ of $3\mu m < d_{sleeve} < 15\mu m$ after drawing in order to mechanically reinforce the conductor element.

2. The conductor element according to claim 1, **characterized in that** the sleeve (7) surrounding the tube (3) comprises tantalum (Ta) or a tantalum alloy.

3. The conductor element according to claim 2, **characterized in that** the sleeve (7) surrounding the tube (3) comprises tantalum (Ta) in an atomic concentration of $C_{Ta, sleeve} \geq 50\%$, preferably $C_{Ta, sleeve} \geq 90\%$.

4. The conductor element according to one of the claims 2 or 3, **characterized in that** the sleeve (7) surrounding the tube (3) comprises tungsten (W) and/or molybdenum (Mb) and/or titanium (Ti) and/or vanadium (V) and/or niobium (Nb).

5. The conductor element according to any one of the preceding claims, **characterized in that** the material (4) located in the tube (3) contains copper (Cu).

6. The conductor element according to any one of the preceding claims, **characterized in that** the inner surface (8) of the tube (3) is coated with copper (Cu) or is lined with a copper sheet.

7. The conductor element according to any one of the preceding claims, **characterized in that** the tube (3) has a maximum outer diameter $d_{max, R}$ after drawing of $3\mu m \leq d_{max, R} \leq 100\mu m$, preferably of $10\mu m \leq d_{max, R} \leq 50$ $\mu m$.

8. The conductor element according to any one of the preceding claims, **characterized in that** the tube (3) has a wall thickness $W_{tube}$ after drawing of $1\mu m < w_{tube} < 20\mu m$.

9. Method for producing a superconductive conductor element according to any one of the preceding claims, wherein, prior to drawing, the outer surface (6) of the tube (3) is directly and completely surrounded by a sleeve (7) of metallic material as a diffusion barrier during the solid diffusion reaction, wherein the sleeve (7) has a thermal expansion coefficient at room temperature of $\alpha_{sheet metal} < 17*10^{-6}$ $K^{-1}$, preferably $\alpha_{sheet metal} \leq 8*10^{-6}$ $K^{-1}$, an elastic limit $R_{p0,2} > 300$ MPa and a cross-sectional reduction A> 20%, and wherein the metallic material is selected to be chemically inert to diffusing tin (Sn) up to a reaction temperature T of the solid diffusion reaction temperature, **characterized in that** the thickness of the material of the sleeve (7) is selected such that the sleeve has a thickness $d_{sleeve}$ after drawing of $3\mu m < d_{sleeve} < 15\mu m$ in order to mechanically reinforce the conductor element.

10. The method according to claim 9 for producing a superconductive conductor element according to any one of the claims 1 through 8, **characterized in that** the solid diffusion reaction is carried out at a reaction temperature T of 400°C ≤ T ≤ 800°C, preferably 550°C ≤ T ≤ 700°C, wherein, in particular, an HIP process (high temperature isostatic pressing) is carried out prior to the solid diffusion reaction.

11. The method according to one of the claims 9 or 10 for producing a superconductive conductor element according to any one of the claims 1 through 8, **characterized in that** the solid diffusion reaction is carried out in an oxygen ($O_2$)-free atmosphere with an oxygen partial pressure of $p_{O2} \leq 10^{-3}$ bar, in particular, in a vacuum or in an inert gas atmosphere that preferably contains argon (Ar) and/or helium (He) and/or nitrogen ($N_2$).

12. The method according to any one of the claims 9 through 11 for producing a superconductive conductor element according to any one of the claims 1 through 8, **characterized in that** the reaction conditions of the solid diffusion reaction, in particular, the reaction temperature T, the reaction time t and/or the heating rates R are selected such that all of the niobium (Nb) contained in the tube (3) of the initial filament structure reacts to $Nb_3Sn$.

## Revendications

1. Élément supraconducteur avec $Nb_3Sn$, plus particulièrement fil multifilament, qui contient au moins un filament (1) supraconducteur, lequel est obtenu à partir d'une structure filamentaire de départ, après une opération d'étirage, par une réaction de diffusion à l'état solide, laquelle structure comporte un long tube creux (3) composé de niobium (Nb) ou d'un alliage de Nb, en particulier de NbTa ou de NbTi, avec une surface interne (8) et une surface externe (6), le tube (3) étant inséré dans une matrice métallique (2), en particulier en cuivre (Cu), à conduction thermique et électrique élevée, et le tube (3) étant rempli d'un matériau (4) poudreux, contenant de l'étain (Sn), la surface externe (6) du tube (3) avant l'opération d'étirage étant directement et entièrement enveloppée d'une enveloppe (7) composée d'un matériau métallique comme dispositif de blocage de diffusion pendant la réaction de diffusion à l'état solide, lequel matériau métallique présente, à température ambiante, un coefficient de dilatation thermique $\alpha_{Enveloppe} < 17{*}\,10^{-6}$ $K^{-1}$, de préférence $\alpha_{Enveloppe} \leq 8{*}\,10^{-6}$ $K^{-1}$, une limite d'étirage $R_{p0,2} >$ 300 MPa et une réduction transversale A > 20 %, et le matériau métallique étant chimiquement inerte par rapport à l'étain diffusé (Sn) jusqu'à une température de réaction T de la température de réaction de diffusion à l'état solide, et la poudre (4) se trouvant dans le tube (3) contenant du $NbSn_2$,
**caractérisé en ce que** l'enveloppe (7) entourant le tube (3) présente après l'opération d'étirage une épaisseur $d_{Enveloppe}$ de 3 $\mu$m < $d_{Enveloppe}$ < 15 $\mu$m pour renforcer mécaniquement l'élément conducteur.

2. Élément conducteur selon la revendication 1, **caractérisé en ce que** l'enveloppe (7) entourant le tube (3) présente du tantale (Ta) ou un alliage de tantale.

3. Élément conducteur selon la revendication 2, **caractérisé en ce que** l'enveloppe (7) entourant le tube (3) présente du tantale (Ta) dans une concentration atomique de $C_{Ta,\ Enveloppe} \geq 50$ %, de préférence $C_{Ta,\ Enveloppe} \geq 90$ %.

4. Élément conducteur selon l'une quelconque des revendications 2 ou 3, **caractérisé en ce que** l'enveloppe (7) entourant le tube (3) présente du tungstène (W) et/ou du molybdène (Mb) et/ou du titane (Ti) et/ou du vanadium (V) et/ou du niobium (Nb).

5. Élément conducteur selon l'une quelconque des revendications précédentes, **caractérisé en ce que** le matériau (4) se trouvant dans le tube (3) contient du cuivre (Cu).

6. Élément conducteur selon l'une quelconque des revendications précédentes, **caractérisé en ce que** la surface interne (8) du tube (3) est enduite de cuivre (Cu) ou habillée d'une plaque de cuivre.

7. Élément conducteur selon l'une quelconque des revendications précédentes, **caractérisé en ce que** le tube (3) présente, après l'opération d'étirage, un diamètre externe maximum de $d_{max,\ R}$ de 3 $\mu$m ≤ $d_{max,\ R} \leq 100$ $\mu$m, de préférence de 10 $\mu$m ≤ $d_{max,\ R} \leq 50$ $\mu$m.

8. Élément conducteur selon l'une quelconque des revendications précédentes, **caractérisé en ce que** le tube (3) présente, après l'opération d'étirage, une épaisseur de paroi $W_{Tube}$ de 1 $\mu$m < $W_{Tube}$ < 20 $\mu$m.

9. Procédé de fabrication d'un élément supraconducteur selon l'une quelconque des revendications précédentes, la surface externe (6) du tube (3) avant l'opération d'étirage étant directement et entièrement enveloppée d'une enveloppe (7) composée d'un matériau métallique comme dispositif de blocage de diffusion pendant la réaction de diffusion à l'état solide, l'enveloppe (7) présentant, à température ambiante, un coefficient de dilatation thermique $\alpha_{Plaque} < 17{*}10^{-6}$ $K^{-1}$, de préférence $\alpha_{Plaque} \leq 8{*}10^{-6}$ $K^{-1}$, une limite d'étirage $R_{p0,2} > 300$ MPa et une réduction transversale A > 20 %, et le matériau métallique étant choisi de sorte qu'il soit chimiquement inerte par rapport à l'étain (Sn) diffusé jusqu'à une température de réaction T de la température de réaction de diffusion à l'état solide,

**caractérisé en ce**

**que** l'épaisseur du matériau de l'enveloppe (7) est choisie, pour un renforcement mécanique de l'élément conducteur, de sorte que l'enveloppe présente après l'opération d'étirage une épaisseur de $d_{Enveloppe}$ de 3 $\mu$m < $d_{Enveloppe}$ < 15 $\mu$m.

10. Procédé selon la revendication 9 destiné à la fabrication d'un élément supraconducteur selon l'une quelconque des revendications 1 à 8, **caractérisé en ce que** la réaction de diffusion à l'état solide est réalisée à une température de réaction T de 400°C $\leq$ T $\leq$ 800°C, de préférence 550°C $\leq$ T $\leq$ 700°C, un processus HIP (High Temperature Isostatic Pressing) étant exécuté plus particulièrement avant la réaction de diffusion à l'état solide.

11. Procédé selon l'une quelconque des revendications 9 ou 10, destiné à la fabrication d'un élément supraconducteur selon l'une quelconque des revendications 1 à 8, **caractérisé en ce que** la réaction de diffusion à l'état solide est réalisée dans une atmosphère sans oxygène ($O_2$) avec une pression partielle en oxygène de $p_{02} \leq 10^{-3}$ mbar, plus particulièrement dans un vide ou dans une atmosphère de gaz inerte, qui contient de préférence de l'argon (Ar) et/ou de l'hélium (He) et/ou de l'azote ($N_2$).

12. Procédé selon l'une quelconque des revendications 9 à 11 destiné à la fabrication d'un élément supraconducteur selon l'une quelconque des revendications 1 à 8, **caractérisé en ce que** les conditions de réaction de la réaction de diffusion à l'état solide, plus particulièrement la température de réaction T, le temps de réaction t et/ou le coefficient de chauffage R, sont choisies de sorte que tout le niobium (Nb) présent dans le tube (3) de la structure filamentaire de sortie réagit avec le $Nb_3Sn$.

**Fig. 1**

**Fig. 2**

Fig. 3

Fig. 4

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Nicht-Patentliteratur**

- **MASAKI SUENAGA ; ALAN F. CLARK.** Filamentary A15 Superconductors. PLENUM PRESS NEW YORK AND LONDON, 1980, 17-22

- **TERENCE WONG ; CHARLES V. RENAUD.** Ti and Ta Additions to Nb3Sn by the Powder in Tube Process. *IEEE Trans. Supercond.,* 2001, vol. 11, 3584-3587